**Europäisches Patentamt**

**European Patent Office**

**Office européen des brevets**

(19)

(11) Veröffentlichungsnummer: **0 386 247**
**A1**

(12) **EUROPÄISCHE PATENTANMELDUNG**
veröffentlicht nach Art. 158 Abs. 3
EPÜ

(21) Anmeldenummer: **89905477.9**

(51) Int. Cl.⁵: **C23C 14/26**

(22) Anmeldetag: **20.01.89**

(86) Internationale Anmeldenummer:
**PCT/SU89/00017**

(87) Internationale Veröffentlichungsnummer:
**WO 89/12117 (14.12.89 89/29)**

(30) Priorität: **31.05.88 SU 4434256**
**15.11.88 SU 4601812**
**15.11.88 SU 4601808**
**15.11.88 SU 4601810**
**15.11.88 SU 4601811**

(43) Veröffentlichungstag der Anmeldung:
**12.09.90 Patentblatt 90/37**

(84) Benannte Vertragsstaaten:
**AT BE CH DE FR GB IT LI NL SE**

(71) Anmelder: **KIEVSKY POLITEKHNICHESKY**
**INSTITUT IMENI 50-LETIA VELIKOI**
**OKTYABRSKOI SOTSIALISTICHESKOI**
**REVOLJUTSII**
**pr. Pobedy, 37**
**Kiev, 252056(SU)**

(72) Erfinder: **LEVCHENKO, Georgy Timofeevich**
**pr. Svobody, 17b-104**
**Kiev, 252215(SU)**
Erfinder: **RADZIKOVSKY, Alexandr**
**Nikolaevich**
**ul. Cheshskaya, 9-25**
**Kiev, 252103(SU)**

(74) Vertreter: **Füchsle, Klaus, Dipl.-Ing. et al**
**Hoffmann . Eitle & Partner Patentanwälte**
**Arabellastrasse 4**
**D-8000 München 81(DE)**

(54) **ANORDNUNG ZUR ABLAGERUNG VON FILMEN UNTER VAKUUM.**

(57) Vorrichtung zum Aufdampfen von Schichten im Vakuum enthält eine Verdampfungskammer /1/ des aufzudampfenden Stoffs mit einem darin untergebrachten aufzudampfenden Stoff /10/, an deren Außenseite ein Heizelement /2/ angebracht ist. Mit der Kammer /1/ steht eine ihr identische Kollimatorkammer /3/ in Verbindung und jede dieser Kammern /1, 3/ ist mit je zwei in einer horizontalen Achse /8/ liegenden Öffnungen /4, 5/ ausgeführt, in deren einer ein Rohrstutzen /6, 7/ angeordnet ist, wobei der Rohrstutzen /6/ der Verdampfungskammer /1/ in der Öffnung /5/ der Kollimatorkammer /3/ aufgenommen ist, und die Verdampfungskammer /1/ selbst mit einem hermetisierenden Element /9/ ausgestattet ist, das in der anderen Öffnung /4/ dieser Kammer /1/ angeordnet ist.

FIG. 1

## VORRICHTUNG ZUM AUFDAMPFEN VON SCHICHTEN IM VAKUUM

### Technisches Gebiet

Die Erfindung bezieht sich auf die Technik zum Aufbringen von Überzügen auf Erzeugnisse, insbesondere auf eine Vorrichtung zum Aufdampfen von Schichten im Vakuum.

Besonders aussichtsreich ist gegenwärtig die Technologie zum Aufdampfen von Schichten auf die vertikal angeordneten Träger, da sie eine maximale Ausbeute an brauchbaren Erzeugnissen infolge einer geringen Verunreinigung der Oberfläche der Träger im Vergleich mit den horizontal liegenden Trägern gewährleistet. Hauptforderungen, die an die Vorrichtungen zum Aufdampfen von Schichten im Vakuum gestellt werden, sind die Gewährleistung einer hohen Gleichmäßigkeit der Schichtdicke und geringe Verluste an aufzudampfenden Stoffen bei gleichzeitiger Einfachheit der Konstruktion der Vorrichtung.

### Zugrundeliegender Stand der Technik

Weit bekannt ist eine Vorrichtung zum Aufdampfen von Schichten im Vakuum (GB, B, 1517085), die in Form eines Schiffchens ausgebildet ist, in welchen der aufzudampfende Stoff untergebracht ist und durch welches der elektrische Strom zum Erhitzen und Verdampfen des aufzudampfenden Stoffs direkt durchgelassen wird. Der Träger ist in der horizontalen Lage gegenüber dem Schiffchen in einiger Entfernung von diesem angeordnet.

Eine solche Vorrichtung zeichnet sich durch hohe Verluste an aufzudampfendem Stoff aus, die durch Fehlen eines gerichteten Stroms des verdampften Stoffs bedingt sind, und kann lediglich zum Aufdampfen von Schichten bei der horizontalen Anordnung der Träger eingesetzt werden.

Zur Erzeugung eines gerichteten Stroms des verdampften Stoffs werden Düsen verwendet, was in einem Verdampfer für Vakuumanlagen verwirklicht ist (SU, A, 397567), der einen Erhitzer, in welchem ein Tiegel mit dem darin untergebrachten zu verdampfenden Stoff angeordnet ist, und eine Düse enthält, die im oberen Teil des Tiegels angebracht ist. Auf der Achse der Düse ist in einiger Entfernung von

- 2 -

deren Austrittskante ein Träger horizontal angeordnet.

Der bekannte Verdampfer zeichnet sich auch durch Vorhandensein im Strom an den Wänden der Düse einer Grenzschicht aus, deren Breite bei den in der Praxis verwendeten Aufdampfungsgeschwindigkeiten einen bedeutenden Teil des Stroms ausmacht. Die von dieser Schicht ausgesandten Moleküle bewegen sich chaotisch und erhöhen die Verluste an aufzudampfendem Stoff.

Eine bedeutende Verminderung der Verluste an aufzudampfendem Stoff läßt sich erreichen, wenn man das Prinzip der Festphasenregenerierung des verdampften, jedoch an den Träger nicht gelangten Stoffs anwendet, was in einer Vorrichtung zum Aufdampfen von Schichten im Vakuum (US, A, 4700660) realisiert ist, die eine Verdampfungskammer des aufzudampfenden Stoffs, an deren Außenseite ein Heizelement angebracht ist, und eine mit ihr in Verbindung stehende Kollimatorkammer enthält, die identisch ausgeführt sind und von denen jede zwei in einer Achse liegende Öffnungen aufweist.

Die Verdampfungskammer des aufzudampfenden Stoffs und die Kollimatorkammer stellen eine Rohrleitung mit querliegender Symmetrieebene dar. Das untere Ende der Verdampfungskammer befindet sich im Tiegel in dem der aufzudampfende Stoff untergebracht ist. Beide Kammern können durch eine in der Symmetrieebene angeordnete Scheidewand mit Öffnung getrennt sein.

Periodisch, je nach Verbrauch und Nachladung des aufzudampfenden Stoffs, dreht man die Rohrleistung um und stellt sie im Tiegel mit dem Ende auf, an dem sich der aufzudampfende Stoff niedergeschlagen hat, welcher auf den Träger nicht gelangt ist. Dieser Stoff verwendet man in einem nachfolgenden Aufdampfzyklus.

Die beschriebene Vorrichtung ist jedoch dazu geeignet, die Schichten nur auf horizontal liegende Träger aufzubringen, da die Möglichkeit des Herausfließens des geschmolzenen aufzudampfenden Stoffs durch undichte Verbindungsstellen zwischen dem unteren Ende der Rohrleitung, das die Verdampfungskammer bildet, und dem Tiegel besteht. Bei den

- 3 -

einfachsten Ausführungsformen der Vorrichtung, wo die Rohrleitung als Ganzes ausgebildet ist, und in der Mitte eine ringförmige Aussparung hat, die die Verdampfungskammer und die Kollimatorkammer voneinander trennt, ist außerdem in der Zone der ringförmigen Aussparung stets eine Kondensation des Stoffs bei beliebiger Lage der Rohrleitung zu verzeichnen. Dabei kommt es zum Überfließen des geschmolzenen aufzudampfenden Stoffs, der sich in der ringförmigen Aussparung gesammelt hat, in eine der Kammern, was zu einer asymmetrischen Änderung der Intensitätsverteilung des aus der Kollimatorkammer austretenden Dampfstroms führen kann, wodurch die Gleichmäßigkeit der Dicke der aufzudampfenden Schicht im Ganzen vermindert wird.

Darüber hinaus gewährleistet eine solche Vorrichtung in ihrer einfachsten Ausführungsform keine hohe Dickengleichmäßigkeit der aufzudampfenden Schicht auf den großflächigen Trägern selbst dann, wenn diese horizontal angeordnet sind, und die Verwendung verschiedener Scheidewände zu diesem Zweck, die man in der Rohrleitung anbringt, macht die Konstruktion der Vorrichtung kompliziert.

Falls man Schichten von beträchtlicher Dicke aufbringt, so verändert die in der Kollimatorkammer kondensierende Stoffschicht die Verteilung der Intensität des aus dieser Kammer austretenden Dampfstroms, was zu einer ungleichmäßigen Dicke der aufzudampfenden Schicht führt.

Überdies führt eine gleichzeitige Verdampfung des aufzudampfenden Stoffs aus dem Tiegel und aus der Verdampfungskammer, deren Temperatur in der Regel sich voneinander etwas unterscheiden, zu einer Veränderung der Geschwindigkeit im Prozeß des Aufdampfens: anfangs verdampft der Stoff mit hoher Geschwindigkeit von der heißeren Fläche (Verdampfungskammer), dann mit geringerer Geschwindigkeit von der weniger heißeren Fläche (Tiegel). Zum Ausgleichen der Verdampfungsgeschwindigkeiten ist es erforderlich, beim Aufdampfprozeß den Heizstrom zu regeln, was die Vorrichtung komplizierter macht.

Offenbarung der Erfindung

Der Erfindung liegt die Aufgabe zugrunde, eine Vor-

- 4 -

richtung zum Aufdampfen von Schichten im Vakuum zu entwickeln, bei der die Aufdampfungskammer und die Kollimatorkammer derart gegenseitig angeordnet und konstruktiv so ausgeführt sind, daß die Möglichkeit zum Aufdampfen von gleichmäßig dicken Schichten mit geringen Verlusten an aufzudampfendem Stoff auf vertikal angeordnete Träger gewährleistet ist.

Die gestellte Aufgabe wird dadurch gelöst, daß in der Vorrichtung zum Aufdampfen von Schichten im Vakuum, die eine Kammer zum Aufdampfen des aufzudampfenden Stoffs, an deren Außenseite ein Heizelement angebracht ist, und eine mit ihr in Verbindung stehende Kollimatorkammer enthält, die identisch ausgeführt sind, wobei jede der Kammern mit je zwei in einer Achse liegenden Öffnungen versehen ist, erfindungsgemäß die Achse der Öffnungen horizontal angeordnet ist, die Verdampfungskammer des aufzudampfenden Stoffs und die Kollimatorkammer mit je einem in einer der Öffnungen befindlichen Rohrstutzen versehen sind, der Rohrstutzen der Verdampfungskammer des aufzudampfenden Stoffs in der anderen Öffnung der Kollimatorkammer aufgenommen ist, wobei die Verdampfungskammer des aufzudampfenden Stoffs mit einem hermetisierenden Element ausgestattet ist, das in der anderen Öffnung derselben angeordnet ist, und der aufzudampfende Stoff direkt in der Verdampfungskammer des aufzudampfenden Stoffs untergebracht ist.

Es ist zweckmäßig, daß die Vorrichtung einen Former des gerichteten Dampfstroms enthält, der in Form énes Stabes ausgebildet ist, der auf der Achse der Öffnungen der Verdampfungskammer des aufzudampfenden Stoffs angeordnet undan deren hermetisierendem Element befestigt ist.

Es ist sinnvoll, daß das freie Ende des Stabes im Rohrstutzen der Verdampfungskammer des aufzudampfenden Stoffs mit einem Spalt in bezug auf dessen Innenfläche angeordnet ist.

Es ist nützlich, daß das freie Ende des Stabes an die Innenfläche des Rohrstutzens der Verdampfungskammer des aufzudampfenden Stoffs angrenzt, und in dem Stab selbst

- 5 -

eine Zentralbohrung und eine Gruppe von mit ihr kommunizierenden, an der Seitenfläche des Stabes angeordneten
Öffnungen ausgeführt sind.

Es ist auch zweckmäßig, daß die Vorrichtung zusätzlich
ein Heizelement enthält, das außen am Stutzenumfang der
Kollimatorkammer angebracht ist.

Es ist recht günstig, das hermetisierende Element mit
dem Hauptheizelement als Ganzes auszubilden.

Die erfindungsgemäße Vorrichtung zum Aufdampfen von
Schichten im Vakuum gestattet es, vertikal angeordnete
Träger zu bearbeiten, was die Homogenität der aufzudampfenden Strukturen und somit auch die Ausbeute an Qualitätserzeugnissen erhöht. Dabei wird eine hohe Gleichmäßigkeit
der Dicke der aufzudampfenden Schicht bei einem geringen
Materialverbrauch gewährleistet. Die Vorrichtung zeichnet
sich durch eine einfache konstruktive Ausführung aus und
ist betriebssicher.

Kurze Beschreibung der Zeichnungen

Im weiteren soll die Erfindung anhand von konkreten
Ausführungsbeispielen und beiliegenden Zeichnungen näher
erläutert werden, in denen es zeigt:

Fig. 1 eine schematische Darstellung der Gesamtansicht
der Vorrichtung zum Aufdampfen von Schichten im Vakuum
(Längsschnitt), gemäß der Erfindung;

Fig. 2 dasselbe wie in Fig. 1, mit einem Former des gerichteten Dampfstroms (Längsschnitt), gemäß der Erfindung;

Fig. 3 dasselbe wie in Fig. 2, mit einer anderen Ausführungsform des Formers des gerichteten Dampfstroms,
einem hermetisierenden Element, das mit dem Heizelement
als Ganzes ausgebildet ist, und einem zusätzlichen Heizelement (Längsschnitt), gemäß der Erfindung.

Beste Ausführungsform der Erfindung

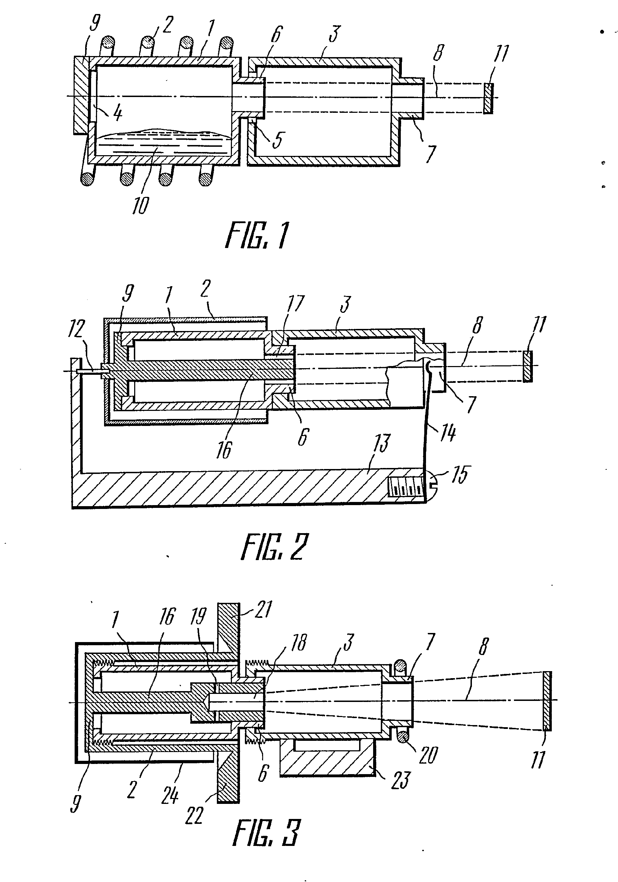

Die Vorrichtung zum Aufdampfen von Schichten im Vakuum
enthält eine Verdampfungskammer 1 (Fig. 1) des aufzudamp-
fenden Stoffs, an deren Außenseite ein Heizelement 2 angebracht ist, und eine mit ihr in Verbindung stehende identische Kollimatorkammer 3. In den Kammern 1, 3 sind Öffnungen 4, 5 vorgesehen und diese Kammern 1,3 sind mit Rohrstützen 6,7 ausgestattet. Die Öffnungen 4, 5 und die Rohrstutzen 6, 7 sind auf einer horizontalen Achse 8 angeordnet, die in dem hier beschriebenen Ausführungsbeispiel der Vorrichtung etwas oberhalb der Symmetrieachse der Kammern 1, 3 liegt. Zum Verbinden, der Kammer 1 und 3 ist der Rohrstutzen 6 der Verdampfungskammer 1 in der Öffnung der Kollimatorkammer 3 aufgenommen. Die Verdampfungskammer 1 ist mit einem hermetisierenden Element 9 versehen, das in der Öffnung 4, z. B. mit Hilfe eines Gewindes (nicht dargestellt), angeordnet ist.

Der aufzudampfende Stoff 10 ist direkt in der Verdampfungskammer 1 untergebracht. Sein Füllstand soll nicht höher liegen als die untere Kante der Öffnung 4.

In der Verdampfungskammer 1 wird die Verdampfungstemperatur des aufzudampfenden Stoffs 10 durch das Heizelement 2 und in der Kollimatorkammer 3 unterhalb des Schmelzpunktes des aufzudampfenden Stoffs 10 aufrechterhalten. Die Kammer 3 ist zur Festphasenregenerierung des verdampften, aber den Rohrstutzen 7 nicht passierten aufzudampfenden Stoffs 10 bestimmt.

In einiger Entfernung von der Austrittsöffnung des Rohrstützens 7 ist auf der Achse 8 ein Träger 11 angeordnet, der zum Aufdampfen einer Schicht auf ihm bestimmt ist.

Die Identität der Kammern 1 und 3 gestattet es, ihre Stellen periodisch zu tauschen, was die Rückführung des in der Kollimatorkammer 3 kondensierten Stoffs 10 zur erneuten Verdampfung gewährleistet.

Die Aufnahme des Rohrstutzens 6 der Verdampfungskammer 1 in der Öffnung 5 der Kollimatorkammer 3 schließt das Eindringen des Dampfes in die Verbindungsstelle zwischen den Kammern 1, 3 aus wodurch das Zusammenlöten der Kammern 1, 3 durch die schmelze des aufzudampfenden Stoffs 10 vermieden und dessen Verluste ausgeschlossen werden.

In der hier beschriebenen Ausführungsform ist das hermetisierende Element 9 auf einem Stift 12 (Fig. 2) an-

- 7 -

geordnet, der an einer in einer Vakuumkammer (nicht dargestellt) befindlichen Tragstütze 13 befestigt ist. Die Kammern 1 und 3 sind an das hermetisierende Element 9 durch eine Feder 14 angedrückt, die in der Tragstütze 13 durch eine Schraube 15 befestigt ist, was eine zuverlässige Hermetisierung der Öffnung 4, darunter auch bei der thermischen Ausdehnung des hermetisierenden Elementes 9 und der Verdampfungskammer 1 gewährleistet.

Am hermetisierenden Element 9 ist ein Former des gerichteten Dampfstroms befestigt, der in Form eines Stabes 16, der längs der Achse 8 verläuft, ausgebildet ist. Das freie Ende des Stabes 16 ist im Rohrstutzen 6 mit einem Spalt 17 angeordnet. Der durch den Ringspalt 17 aus tretende Dampfstrom gewährleistet eine gleichmäßigere Dicke der auf dem Träger 11 zu bildenden Schicht. Das Ende des Stabes 16, wie auch der Rohrstutzen 6, kann eine andere Form haben, z. B. eine Kegelform (nicht dargestellt), was eine gleichmäßige Schichtdicke auf größeren Trägern 11 gewährleistet.

Die Kammern 1, 3, das hermetisierende Element 9 und der Stab 16 können aus Graphit oder einem schwerschmelzenden Metall, z. B. Molybdän, hergestellt sein. Das Heizelement 2 kann aus einem schwerschmelzenden Blechmetall bestehen und in den (nicht gezeichneten) Stromzuführungen der Vorrichtung befestigt sein.

In einer anderen Ausführungsform der Vorrichtung (Fig. 3) grenzt das freie Ende des Stabes 16 an die Innenfläche des Rohrstutzens 6 der Verdampfungskammern 1 an. In diesem Falle sind in dem Stab 16 eine Zentralbohrung 18 und eine mit ihr in Verbindung stehende Gruppe von Öffnungen 19 ausgeführt, die an der Seitenfläche des Stabes 16 angebracht sind.

Bei diesem Ausführungsbeispiel der Vorrichtung ist ein zweites Heizelement 20 vorgesehen, das außen am Umfang des Rohrstutzens 7 der Kollimatorkammer 3 angeordnet ist. Dieses kann auch aus einem schwerschmelzenden Metall bestehen und an die Stromzuführungen (nicht gezeichnet)

- 8 -

angeschlossen sein. Im Aufdampfprozeß gewährleistet das Heizelement 20 eine periodische Erhöhung der Temperatur des Rohrstutzens 7 über den Schmelzpunkt des aufzudampfenden Stoffs 10 (Fig. 1) hinaus für dessen Abfluß in die Kollimatorkammer 3, was die Aufdampfung einer dicken Schicht auf den Träger 11 ohne Verminderung ihrer Qualität zu verwirklichen erlaubt.

Das Heizelement 2 (Fig. 3) ist in der vorliegenden Ausführungsvariante mit dem hermetisierenden Element 9 als ein Ganzes ausgebildet, was eine garantierte Durchwärmung des Elementes 9, dessen Temperatur nicht unter der Temperatur in der Verdampfungskammer 1 liegen soll, gewährleistet.

Das Heizelement 2 weist Abzweigungen 21 und 22 auf, mit deren Hilfe es in den (nicht gezeichneten) Stromzuführungen befestigt ist. Längs der Achse des Heizelementes 2 ist ein Schlitz (nicht dargestellt) vorgesehen, der eine optimale Verteilung des elektrischen Stroms über die gesamte Oberfläche des Heizelementes 2 gewährleistet. Das Heizelement 2 mit dem hermetisierenden Element 9 und den Abzweigungen 21, 22 kann aus Graphit hergestellt sein.

Die Verdampfungskammer 1 kann mit dem hermetisierenden Element 9 mittels einer Gewindeverbindung, die eine zuverlässige Hermetisierung der Kammer 1 gewährleistet, verbunden sein. Die Kollimatorkammer 3 ist auf einem Auflager 23 aufgesetzt, und in der Nähe des Heizelementes 2 und des hermetisierenden Elementes 9 ist zwecks Verminderung der Wärmestrahlung ein Wärmeschild 24, der aus einem schwerschmelzenden Blechmaterial besteht, montiert.

Die Vorrichtung zum Aufdampfen von Schichten arbeitet wie folgt.

In die Verdampfungskammer 1 (Fig. 1) wird der aufzudampfende Stoff 10 eingefüllt. Nach der Unterbringung des Trägers 11 und der gesamten Vorrichtung in der (nicht gezeichneten) Vakuumkammer wird aus dieser die Luft bis zum Betriebsdruck ausgepumpt. Dann wird das Heizelement 2 eingeschaltet. Dabei steigt die Temperatur in der Verdampfungskammer 1 an und der darin befindliche Stoff erwärmt sich bis auf die erforderliche Verdampfungstemperatur. Der erzeugte Dampf verläßt den Rohrstützen 6, ein Teil von ihm passiert den Rohrstutzen 7 und schlägt sich auf dem Träger 11 nieder, während ein anderer Teil, der an den Träger nicht gelangt ist, auf der Innenfläche der Kollimatorkammer 3 kondensiert.

Nach Aufbringen einer erforderlichen Schicht auf den Träger 11 wird das Heizelement 2 ausgeschaltet. Danach wird in die Kollimatorkammer, falls erforderlich, der aufzudampfende Stoff 10 nachgefüllt und die Kammern 1 und 3 werden gegenseitig ausgetauscht. Somit wird der an den Wänden der Kollimatorkammer 3 niedergeschlagene Stoff 10 im nachfolgenden Aufdampfzyklus wie auch der neugeladene eingesetzt.

Die Vorrichtung, deren hermetisierendes Element 9 und die Kammern 1, 3 auf der Tragstütze 13 (Fig. 2) mit Hilfe eines Stiftes 12 und einer Feder 14 montiert sind, arbeitet auf ähnliche Weise. Diese Vorrichtung gewährleistet eine höhere Gleichmäßigkeit der Schichtdicke, da der aus dem Spalt 17 austretende und ringförmig gestaltete Dampfstrom bei seinem Durchgang durch die Kollimatorkammer 3 in einen Vollstrom übergeht. Periphere Bereiche dieses Stroms kondensieren an den Wänden der Kammer 3, und der zentrale Teil erreicht den Träger 11 und formt auf dieser eine gleichmäßig dicke Schicht. Eine solche Vorrichtung mit dem Stab 16, dessen Ende im Rohrstutzen 6 mit Spalt 17 angeordnet ist, ist zweckmäßig beim Bedampfen großflächiger Träger, bei denen das Verhältnis ihres Durchmessers zur Entfernung bis zum Rohrstutzen 6 mehr als 0,4 ausmacht, zu verwenden.

In ähnlicher Weise funktioniert die in Fig. 3 dargestellte Vorrichtung. Die Vorrichtung zeichnet sich besonders dadurch aus, daß der verdampfte Stoff aus der Verdampfungskammer 1 in die Kollimatorkammer 3 durch die Öffnungen 19 in der Seitenfläche des Stabes 13 und die Zentralbohrung

- 10 -

18, die im freien Ende des Stabes 16 ausgebildet ist, gelangt. Nach Austritt aus der Bohrung 18 bildet sich ein gerichteter divergenter Dampfstrom, was mit Hilfe der erfindungsgemäßen Vorrichtung das Aufdampfen der Schicht auf die verschieden großen Träger 11 ermöglicht.

Beim Bedampfen der Träger 11 mit dicken Schichten wird beim Aufdampfen das Heizelement 20 periodisch eingeschaltet, damit der im Rohrstutzen 7 niedergeschlagene aufzudampfende Stoff schmilzt und in die Kollimatorkammer 3 zurückfließt. Auf diese Weise wird eine Verminderung des Innendurchmessers des Rohrstutzens 7, die zur Herabsetzung der Aufdampfungsgeschwindigkeit und der Gleichmäßigkeit der Dicke der aufzudampfenden Schicht führt, vermieden.

Somit wird mit Hilfe der erfindungsgemäßen Vorrichtung zum Aufdampfen von Schichten im Vakuum die Möglichkeit zum Aufdampfen der Schichten auf vertikal angeordnete Träger gewährleistet und eine hohe Gleichmäßigkeit der Schichtdicke bei geringem Materialverbrauch erzielt.

Gewerbliche Verwertbarkeit

Die Vorrichtung zum Aufdampfen von Schichten im Vakuum, vorzugsweise von teuren Metallen wie Gold, Silber, Platin, Palladium, kann in der Elektronentechnik, Rundfunktechnik und Akustik bei der Herstellung z. B. von integrierten Schaltungen sowie bei der Metallisierung und bei der Nachstimmung von Quarzresonatoren im Vakuum eingesetzt werden.

- 11 -

PATENTANSPRÜCHE:

1. Vorrichtung zum Aufdampfen von Schichten im Vakuum, die eine Verdampfungskammer (1) des aufzudampfenden Stoffs, an deren Außenseite ein Heizelement (2) angebracht ist, und eine mit ihr in Verbindung stehende Kollimatorkammer (3) enthält, die identisch ausgeführt sind, wobei jede der Kammern je zwei in einer Achse (8) liegende Öffnungen (4, 5) aufweist, dadurch g e k e n n z e i c h - n e t, daß die Achse (8) der Öffnungen (4, 5) horizontal angeordnet ist, die Verdampfungskammer (1) des aufzudampfenden Stoffs und die Kollimatorkammer (3) mit je einem in einer der Öffnungen befindlichen Rohrstutzen (6, 7) versehen sind, der Rohrstutzen (6) der Verdampfungskammer (1) des aufzudampfenden Stoffs in der anderen Öffnung (5) der Kollimatorkammer (3) aufgenommen ist, wobei die Verdampfungskammer (1) des aufzudampfenden Stoffs mit einem hermetisierenden Element (9) ausgestattet ist, das in der anderen Öffnung (4) derselben angeordnet ist, und der aufzudampfende Stoff (10) direkt in der Verdampfungskammer (1) des aufzudampfenden Stoffs untergebracht ist.

2. Vorrichtung nach Anspruch 1, dadurch g e k e n n - z e i c h n e t, daß sie einen Former des gerichteten Dampfstroms enthält, der in Form eines Stabes (16) ausgebildet ist, der auf der Achse (8) der Öffnungen (4) der Verdampfungskammer (1) des aufzudampfenden Stoffs angeordnet und an deren hermetisierendem Element (9) befestigt ist.

3. Vorrichtung nach Anspruch 2, dadurch g e k e n n - z e i c h n e t, daß das freie Ende des Stabes (16) im Rohrstutzen (6) der Verdampfungskammer (1) des aufzudampfenden Stoffs mit einem Spalt (17) in bezug auf dessen Innenfläche angeordnet ist.

4. Vorrichtung nach Anspruch 2, dadurch g e k e n n - z e i c h n e t, daß das freie Ende des Stabes (16) an die Innenfläche des Rohrstutzens (6) der Verdampfungskammer (1) des aufzudampfenden Stoffs angrenzt, und in

- 12 -

dem Stab (16) selbst eine Zentralbohrung (18) und eine Gruppe von mit ihr kommunizierenden, an der Seitenfläche des Stabes (16) angeordneten Öffnungen (19) ausgeführt sind.

5. Vorrichtung nach Anspruch 1 oder 2 oder 3 oder 4, dadurch g e k e n n z e i c h n e t, daß sie zusätzlich ein Heizelement (20) enthält, das außen am Umfang des Rohrstutzens (7) der Kollimatorkammer (3) angebracht ist.

6. Vorrichtung nach Anspruch 1, dadurch g e k e n n - z e i c h n e t, daß das hermetisierende Element (9) mit dem Hauptheizelement (2) als Ganzes ausgebildet ist.

7. Vorrichtung nach Anspruch 5, dadurch g e k e n n - z e i c h n e t, daß das hermetisierende Element (9) mit dem Hauptheizelement (2) als Ganzes ausgebildet ist.

FIG. 1

FIG. 2

FIG. 3

899054779.9                                                    ∞-70

# INTERNATIONAL SEARCH REPORT

International Application No  PCT/SU 89/00017

| I. CLASSIFICATION OF SUBJECT MATTER (If several classification symbols apply, indicate all) |
|---|
| According to International Patent Classification (IPC) or to both National Classification and IPC |

IPC$^4$ C 23 C 14/26

## II. FIELDS SEARCHED

| Minimum Documentation Searched |
|---|

| Classification System | Classification Symbols |
|---|---|
| IPC$^4$ | C 23 C 14/26, 14/24, 14/28 |

| Documentation Searched other than Minimum Documentation<br>to the Extent that such Documents are Included in the Fields Searched |
|---|
|  |

## III. DOCUMENTS CONSIDERED TO BE RELEVANT

| Category | Citation of Document, with indication, where appropriate, of the relevant passages | Relevant to Claim No. |
|---|---|---|
| A | SU, A1, 1031524 (Moskovsky aviatsionny tekhnologichesky institut im. K.E. Tsiolkovskogo) 30 July 1983 (30.07.83), see fig. 1, column 2, lines 24-27 | 1 |
| A | SU, A1, 1257115, (Kievsky politekhnichesky institut), 15 September 1986 (15.09.86), see column 2, lines 25-35, column 3, lines 25-55, fig. 1 | 1,4,5 |
| A | US, A, 3572672, (RCA CORPORATION), 30 November 1971 (30.11.71), see column 2, lines 25-45, the drawing | 1,5 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art.

"&" document member of the same patent family

## IV. CERTIFICATION

| Date of the Actual Completion of the International Search | Date of Mailing of this International Search Report |
|---|---|
| 06 July 1989 (06.07.89) | 7 August 1989 (07.08.89) |
| International Searching Authority | Signature of Authorized Officer |
| ISA/SU | |

Form PCT/ISA/210 (second sheet) (January 1985)